# EUROPÄISCHE PATENTSCHRIFT

(11) **EP 4 411 090 B1**
(45) Veröffentlichungstag und Bekanntmachung des Hinweises auf die Patenterteilung: **15.07.2026**
(21) Anmeldenummer: 23155230.8
(22) Anmeldetag: 06.02.2023
(51) Int. Cl.: E04H 5/04, H05K 7/14, H05K 7/20

(54) **CONTAINER FÜR ELEKTRONISCHE BAUGRUPPEN EINER REGENERATIVEN ENERGIEQUELLE UND ANLAGE MIT DEM CONTAINER**
CONTAINER FOR ELECTRONIC MODULES OF A REGENERATIVE ENERGY SOURCE AND FACILITY COMPRISING THE CONTAINER
CONTENEUR POUR MODULES ÉLECTRONIQUES D'UNE SOURCE D'ÉNERGIE RÉGÉNÉRATIVE ET INSTALLATION COMPRENANT LE CONTENEUR

(43) Veröffentlichungstag der Anmeldung: 07.08.2024
(73) Patentinhaber: Kiesling Fahrzeugbau GmbH, 89160 Dornstadt-Tomerdingen (DE)
(72) Erfinder: Kiesling, Peter, 89081 Ulm (DE)
(74) Vertreter: Baur & Weber Patentanwälte PartG mbB

(56) Entgegenhaltungen:
- WO-A1-2022/015152
- DE-A1- 10 142 103
- DE-A1- 102019 132 057
- US-A- 5 735 639
- US-A- 5 761 854
- ANONYMOUS: "ABB Solar-Wechselrichter", BROSCHÜRE, 31 December 2015 (2015-12-31), XP055604701, Retrieved from the Internet <URL:https://www.solarmarkt.ch/artimg/20-Wechselrichter/ABB/Hersteller/PU_DE_ABB_Solar-Wechselrichter.pdf> [retrieved on 20190711]

## Beschreibung

Die Erfindung betrifft einen Container für elektronische Baugruppen einer regenerativen Energiequelle und eine Anlage zum Betrieb einer regenerativen Energiequelle in Form einer Solaranlage.

Regenerative Energiequellen werden zunehmend stärker genutzt und sind ein wichtiger Bestandteil beim Erreichen von Klimazielen, um CO₂-Emissionen zu reduzieren. Neben einer Installation auf einem Wohngebäude werden auch Dächer von Industrieanlagen oder Produktionshallen mit Solaranlagen bestückt. Die so gewonnene Energie kann über Trafostationen in das lokale Stromnetz eingespeist werden. Des Weiteren hat es sich bewährt, Batterien als Zwischenspeicher vorzusehen.

Um Batteriespeicher oder große Server gemäß den Herstellerrichtlinien ordnungsgemäß zu betreiben, müssen diese in wärmegedämmtem Räumen betrieben werden. Derzeit werden hierfür Lithium-Ionen oder Eisen-Phosphat-Batterien vorgesehen, welche auch teilweise mit einer entsprechenden Temperierung versehen werden. Häufig liegen die vorgeschrieben Temperaturen beispielsweise für Server und Batteriespeicher bei Raumtemperatur, d. h. zwischen 20 °C und 25 °C.

Bisherige Lösungen zum Einbau von Stromspeichern sind in bestehenden Gebäuden, in Containern oder in Gebäuden, welche auch für Trafostationen verwendet werden, realisiert worden. Da diese Lösungen ursprünglich für andere Zwecke gebaut und teilweise umgebaut werden müssen, wird der Benutzer in der Praxis mit einigen Nachteilen konfrontiert. Dazu gehören im Falle von bestehenden Gebäuden das Problem der sehr hohen Brandlast bei Einbau z.B. von Batteriespeichern. Diese sind zumeist aus Lithium-Ionen oder Eisen-Phosphat-Batterien hergestellt und sind nur schwer im Brandfall zu löschen. Zudem besteht die Gefahr von Verpuffungen (z.B. explodierende Kondensatoren in Wechselrichtern der Batteriespeicher). Selbst, falls in Gebäuden die Feuerwiderstandsklasse F 90 (Feuerwiderstandsdauer 90 Minuten) realisiert wird, sind diese Batterietypen nur sehr schwer zu löschen, so dass, auch bei rechtzeitigem Einsatz der Feuerwehr, dennoch die angrenzenden Gebäude und das Inventar erheblich beschädigt werden können. Teilweise lässt man im Brandfall diese Energiespeicher gezielt abbrennen. In separat zu erstellenden Gebäuden, welche außerhalb der Betriebsstätte angeordnet sind, stellt eine sehr kostenintensive Lösung dar. Zudem ist die Flexibilität eingeschränkt, z.B. falls das Gebäude versetzt werden sollte.

Im Falle von Einsatz in Containern sieht eine bisher praktizierte Möglichkeit vor, dass diese Batterien oder andere feuergefährliche elektrische Bauteile in freistehenden, nicht mit Gebäuden in Verbindung stehenden Containern untergebracht werden. Falls die Wartung der elektrischen Bauteile von außen über Seitentüren erfolgt, ist die Flexibilität eingeschränkt, da direkt vor der Seiten- oder Hecktüre das elektrische Bauteil angeordnet sein muss, um dies zu warten oder auswechseln zu können. In der Regel sind diese Bauteile (Stromspeicher, Wechselrichter, Steuerbox, Server etc.) unterschiedlich groß und werden, je nach Anforderung, unterschiedlich kombiniert.

Somit erhält man in der Praxis unterschiedliche auftragsbezogene Varianten, welche die wirtschaftliche Fertigung des Containers negativ beeinflussen. Erforderliche Wartungsarbeiten müssen im Freien durchgeführt werden. Zu viele Türen verschlechtern zudem die oben beschriebene Isolation des Containers.

Beim Einsatz in Trafostationen kommt hinzu, dass diese in herkömmlicher Betontechnik gefertigt und entsprechend teuer sind. Die Bauteile sind dickwandig und schwer, so dass besondere Transportmittel zur Anlieferung der Gebäudeteile oder der vorgefertigten Station eingesetzt werden müssen. Auch kann eine Vorinstallation kaum stattfinden, da diese Stationen meist am Aufstellungsort erst endmontiert werden.

Neben der Installation von Batteriespeichern werden oftmals auch große Server in eigenen Containern installiert. Derartige Computeranlagen benötigen ebenfalls eine temperierten, um die Leistungsfähigkeit der elektronischen Baugruppen zu erhalten.

In der EP 2 879 475 A1 wird ein Solarwechselrichter beschrieben, der einen Gleichstromeingang zum Anschluss an photovoltaische Geräte, einen Wechselstromausgang zum Anschluss an ein Wechselstromnetz, eine erste geschlossene Zone und eine zweite, teilweise geschlossene Zone umfasst. Der Solar-wechselrichter umfasst eine Kondensatorbank mit einem oder mehreren Kondensatoren zur Aufrechterhaltung einer Zwischenkreisspannung, einen Wandler zur Umwandlung der Zwischenkreisspannung in eine Wechselspannung und eine Spulenbox, die zwischen dem Wandler und dem Wechselstromausgang angeschlossen ist. Der Spulenkasten enthält eine oder mehrere Induktivitäten, ist in der zweiten Zone montiert, hat Anschlüsse an den Umrichter, die für die erste Zone zugänglich sind, und ist ansonsten durch einen Luftspalt von einem Außengehäuse der ersten Zone getrennt.

Die JP 6 005 995 B2 beschreibt eine Transformationseinheit, die den Aufwand für die unterirdische Verdrahtung verringern oder beseitigen kann, die erforderliche Anzahl von Erdfehlerdetektoren verringern kann und auch die Kombinationsprüfung vor Ort verringern oder beseitigen kann. Die Kabel in einem ersten Kanal, der zwischen einem Container und einem Aufwärtstransformator installiert ist, und die Kabel in einem zweiten Kanal, der zwischen dem Aufwärtstransformator und der einer Systemverbindungsplatine installiert ist, werden mit einem gewissen Abstand oder mehr verlegt, der keinen dielektrischen Durchschlag für die Innenwandfläche des Kanals verursacht, und an Ort und Stelle befestigt.

Die US 8 482 163 B2 beschreibt eine Wechselrichtereinheit, die ein Gehäuse, einen Wechselrichter innerhalb des Gehäuses und eine Kühlquelle in thermischer Verbindung mit dem Wechselrichter umfasst, wobei der Wechselrichter eine Nennausgangsleistung bei einer ersten Temperatur hat und die Kühlquelle so konfiguriert ist, dass sie den Wechselrichter auf oder unter einer zweiten Temperatur hält, die ausreicht, um zu ermöglichen, dass der Wechselrichter übersteuert wird, um die Ausgangsleistung in Reaktion auf erfasste Last- und Temperaturbedingungen um 5 % oder mehr über die Nennausgangsleistung zu erhöhen.

In der US 11 382 242 B2 wird ein Leistungselektroniksystem mit einem gegen die Umgebung abgedichteten Elektronikraum zur Unterbringung von Leistungselektronikgeräten beschrieben. Das System umfasst einen Sammelraum innerhalb des abgedichteten Elektronikfachs zur Luftzirkulation. Ein erster Flüssigkeitskühlkreislauf ist so konfiguriert, dass er die durch den Sammelraum strömende Luft kühlt. Ein zweiter Flüssigkeitskühlkreislauf ist so konfiguriert, dass er die Leistungselektronikausrüstung direkt kühlt. Das System umfasst einen Regler, der so konfiguriert ist, dass er die Durchflussmenge des ersten Flüssigkeitskühlkreislaufs und des zweiten Flüssigkeitskühlkreislaufs unabhängig voneinander regelt.

Die DE 10 2019 132057 A1 zeigt einen mobilen Prüfcontainer und eine Anordnung aus zumindest zwei mobilen Prüfcontainern, die für das Prüfen von Antriebselementen, insbesondere von E-Motor und Getrieben, einschließlich einer Umweltsimulation geeignet sind.

Die US 5 735 639 A zeigt eine mobile Sicherheitsstruktur für die Lagerung und Handhabung von Behältern mit gefährlichen Materialien, die mehrere modulare Lagereinheiten umfasst. Die modularen Lagereinheiten können in Tandemanordnung konfiguriert werden. In dieser Konfiguration wird der Zugang zwischen den Innenräumen benachbarter modularer Lagereinheiten durch einen Faltenbalg bereitgestellt, der mit einem Faltenbalgträgerrahmen in einer Seitenwand jeder modularen Lagereinheit verbunden und von diesem abnehmbar ist. Die modularen Lagereinheiten können auch in einer gestapelten Anordnung konfiguriert werden. Jede modulare Lagereinheit umfasst außerdem Vorder-, Rück- und Seitenwände sowie ein Dach aus einer sehr stabilen Konstruktion, bei der Innen- und Außenflächen aus Stahlplatten bestehen, die von einem allgemein rechteckig geformten Stahlrohrrahmen für jede Wand und das Dach der mobilen Sicherheitsstruktur getragen werden.

Die US 5 761 854 A zeigt eine Anordnung, die Vorteile von Rahmenkonstruktionen und Zelten in einem tragbaren, zusammenlegbaren Unterstand kombiniert, indem sie Standard-Schiffscontainerkonstruktionen so modifiziert, dass sie abklappbare Seitenwände aufweisen, die die Grundfläche des Containers erweitern und mit einer einziehbaren Stoffabdeckung versehen sind, um den erweiterten Raum zu umschließen.

Die DE 101 42 103 A1 zeigt, dass bei einer Raumzelle zum Schutz einer Senderanlage oder anderer elektrotechnischer Geräte für die Telekommunikation mit wenigstens einem Lüfterelement sowie mit Entlüftungsdurchbrüchen in zumindest einer Zellenwandung in einem Lüftungsdurchbruch des Dachbereiches der Raumzelle wenigstens ein Lüfterelement sowie im Innenraum der Raumzelle zumindest ein Kühlgerät zum Kühlen der Innenluft angeordnet sind. Ein Verflüssiger und ein Verdampfer des mit gesondertem Luftkreislauf versehenen Kühlgerätes sind zumindest einem Wanddurchbruch vorgeordnet. Nahe dem Verdampfer ist in der Frontwand eines Gehäuses des Kühlgerätes eine Luftaustrittsöffnung vorgesehen. Zur Klimatisierung der Raumzelle wird die Zuluft mit dem innenliegenden Kühlgerät gekühlt, während das dachwärtige Lüftungselement betätigt wird.

Die WO 2022/015152 A1 zeigt eine Umfassungsstruktur zur Unterbringung eines Geräts für die Bewirtschaftung fester Abfälle. Das Gehäuse hat die Form eines Containers und eines Anhängers oder einer fahrzeugmontierten Version. Die Umfassungsstruktur umfasst eine Vorderwand und eine Rückwand mit mindestens einer elektrischen Steckdose und einem Versorgungsanschluss, eine erste und eine zweite Seitentür mit einer Vielzahl von Hydraulikzylindern, die die Seitentüren innerhalb von 30 Sekunden hydraulisch antreiben, einen Dachzugang mit vier Hauptöffnungsklappen zur Ermöglichung des Betriebszugangs und der Wartung, einen Boden, der als Plattform zum Aufstellen der Vorrichtung für die Bewirtschaftung fester Abfälle dient, und elektrische Schalttafeln zur Steuerung des Betriebs der Umfassungsstruktur.

Die Broschüre "ABB Solar-Wechselrichter" (https://www.solarmarkt.ch/artimg/20-Wechselrichter/ABB/Hersteller/PU_DE_ABB_Solar-Wechselrichter.pdf) beschreibt Containerlösungen für Solaranalgen mit getrennten Räumen und Zentral-Wechselrichtern in einem der Räume.

Es besteht daher ein Bedarf, einen Container bzw. eine Anlage mit einem Container zu schaffen, die eine verbesserte Temperierung in Zusammenhang mit dem Betrieb einer regenerativen Energiequelle ermöglichen.

Diese Aufgabe wird durch die Merkmale des Patentanspruchs 1 gelöst. Weitere vorteilhafte Ausgestaltungen der Erfindung sind jeweils Gegenstand der Unteransprüche. Diese können in technologisch sinnvoller Weise miteinander kombiniert werden. Die Beschreibung, insbesondere im Zusammenhang mit der Zeichnung, charakterisiert und spezifiziert die Erfindung zusätzlich.

Gemäß der Erfindung wird ein Container für elektronische Baugruppen geschaffen, insbesondere einer regenerativen Energiequelle oder einer Computeranlage, umfassend Seitenwände mit wenigstens einer Tür zum Zugang ins Innere des Containers, einem Bodenelement und einem Deckenelement, wobei das Innere des Containers in zwei durch eine Trennwand getrennte Kammern aufgeteilt ist, wobei die beiden Kammern über wenigstens ein Klimagerät unterschiedlich einstellbare zulässige Temperaturbereiche aufweisen, wobei wenigstens die Seitenwände eine Innendeckschicht und eine Außendeckschicht aus elektrisch leitfähigem Material, vorzugsweise Stahlblech oder Aluminiumblech, sowie einen Schaumkern, vorzugsweise aus Polyurethan, zur thermischen Isolation aufweisen, wobei die elektronischen Baugruppen entlang eines Ganges im Inneren der Kammern angeordnet sind.

Der Container ist für eine Anlage zum Betrieb einer regenerativen Energiequelle in Form einer Solaranlage vorgesehen. In einer ersten Kammer der zwei Kammern mit engem Temperaturbereich ist ein Batteriespeicher eingebracht, und in einer zweiten Kammer der zwei Kammern mit weiterem Temperaturbereich sind wenigstens die Wechselrichter zum Betrieb der Solaranlage angeordnet.

Der Container wird aus Seitenwänden zusammengesetzt, die ähnlich zu einem Kühlkoffer eines Kühlfahrzeugs mit einer Innendeckschicht und einer Außendeckschicht aus Metall ausgeführt sind, zwischen welchen ein Schaumkern eingebracht ist, sodass eine hohe Wärmeisolation erreicht werden kann. Vervollständigt wird der Container durch ein Bodenelement und ein Deckenelement, das ähnlich wie die Seitenwände ebenfalls mit einem Schaum kann ausgeführt sein kann. Der Container kann dabei bezüglich seiner Außenmaße so ausgeführt sein, dass ein Verladen auf einem Anhänger oder Tieflader möglich ist, der ohne spezielle Schwertransportkennzeichnung auf öffentlichen Straßen geführt werden kann. Mittels entsprechender Befestigungsvorrichtung ist der Container auch auf einfache Weise an einen anderen Aufstellungsort versetzbar. Die elektronischen Baugruppen können auch vorab zumindest teilweise im Inneren des Containers bestückt sein.

Gemäß einer Ausführungsform der Erfindung ist eine von außen anschließbare Löschwassereinrichtung zum Fluten des Containers vorgesehen.

Auf diese Weise ist es möglich, einen eventuellen Brand im Inneren des Containers zu löschen, ohne den Container selbst betreten zu müssen. Die erforderliche Wasserleitung kann dabei in größerer Entfernung zum Container bedient werden, sodass keine Gefahr für Einsatzkräfte der Feuerwehr aufgrund von Brandüberschlag besteht. Hierbei ist es insbesondere vorteilhaft, wenn eine flüssigkeitsdichte Bodenwanne zum Auffangen dekontaminierten Löschwassers vorgesehen ist. Eventuell von außen eingeführte Kabel- oder Leitungsdurchführungen werden ebenfalls flüssigkeitsdicht ausgeführt, was auf einfache Weise zum Beispiel mit einem PU-Schaum erfolgen kann. Der Container selbst kann so aufgestellt werden, dass ein Mindestabstand zu einem Gebäude eingehalten wird, der für Brandüberschlag typischerweise 5 m betragen kann. Auf diese Weise entfällt auch eine eventuelle verpflichtende Feuerwiderstandsklasse der Wände des Containers, was die Herstellungskosten reduziert.

Gemäß einer weiteren Ausführungsform der Erfindung ermöglichen die beiden Kammern eine räumliche Trennung der elektronischen Baugruppen hinsichtlich ihrer Leistungsabgabe.

Im Inneren des Containers sind zwei Temperaturbereiche ausgebildet, sodass elektronische Baugruppen mit unterschiedlichen Anforderungen bezüglich ihres Temperaturbereichs in getrennten Kammern untergebracht werden können. Der Batteriespeicher einer Solaranlage ist in einer Kammer angeordnet, die eine engeres Temperaturfenster, zum Beispiel zwischen 20 °C und 25 °C, aufweist. In die andere Kammer sind ein Wechselrichter sowie gegebenenfalls andere elektronische Baugruppen angeordnet.

In einer anderen nicht beanspruchten Ausführungsform kann in einer Kammer ein Server untergebracht werden, während die andere Kammer mit einem Batteriespeicher zum Weiterbetrieb des Servers bei fehlender Netzversorgung bestückt ist.

Gemäß einer weiteren Ausführungsform der Erfindung sind die Temperaturbereiche der Kammern über ein Zwei-Verdampfer-System oder über ein Ein-Verdampfer-System und einer Lüfteranordnung regelbar.

Dieses Klimagerät kann ein Ein- oder ein Zwei-Verdampfer-System für getrennte Klimatisierung der jeweiligen Kammer aufweisen. Bei einem Klimagerät mit Ein-Verdampfer für nur eine Kammer. Kann ein mit einem Thermostat gesteuerter Lüfter in der Trennwand vorgesehen sein. Dadurch kann der Energieeinsatz deutlich reduziert werden, da nur die Batteriespeicher oder andere temperaturempfindliche Bauteile (Server etc.) zwingend in einen vorgeschriebenen Temperaturbereich (gewöhnlich +20 Grad bis +25 Grad Celsius) betrieben werden müssen. Bei warmer Außentemperatur wird von der klimatisierten Kammer so lange Luft in die andere Kammer geblasen, bis die gewünschte Temperatur der zweiten Kammer erreicht wird. Optional kann bei kalter Außentemperatur von der warmen, nicht klimatisierten Kammer warme Luft umgekehrt in die erste Kammer geblasen. Bei günstigen Temperaturen kann dadurch auf den Betrieb der Klimaanlage komplett verzichtet werden.

Gemäß einer weiteren Ausführungsform der Erfindung ist die Trennwand mit einer verschließbaren Zugangsöffnung versehen, um über die Türe einen Zugang in beide Kammern oder einen Fluchtweg zu ermöglichen.

Die Trennwand kann mit einer Schiebetür oder Pendeltüre als Zugangsöffnung ausgerüstet sein.

Gemäß einer weiteren Ausführungsform der Erfindung sind zwei Türen auf gegenüberliegenden Seiten des Containers vorgesehen, um einen Zugang in beide Kammern oder einen Fluchtweg zu ermöglichen.

Durch die stirnseitig angebrachten Türen können beide Kammern auch ohne eine Durchgangstüre in der Trennwand erreicht werden.

Besonders vorteilhaft ist es, wenn die Tür oder die Türen Panikverschlüsse im Inneren aufweisen. Auf diese Weise ist es möglich, die die Kammern jederzeit verlassen zu können.

Gemäß einer weiteren Ausführungsform der Erfindung ist ein Zwischenboden eingebracht, der auf einem Ständerwerk ruht und auf dem die elektronischen Baugruppen angeordnet sind. Dabei kann der Bereich unter dem Zwischenboden als Kabelzuführung über wenigstens einem Durchbruch in der Seitenwand dienen. Vorteilhaft ist es, wenn an den Seitenwänden mehrere Durchbrüche vorgesehen sind, die vorzugsweise spiegel- oder rotationssymmetrisch zueinander an den Seitenwänden angeordnet sind.

Der Container kann mit einem Doppelboden ausgeführt sein, welcher die Verlegung von Hochvoltleitungen und deren Einleitung in den Container im Erdreich zulässt. Somit ist die Verlegung der Hochwaldleitungen besonders geschützt, da keine oberirdische Leitungsführung erfolgen muss. Die isolierten Seitenwände sind innen und außen mit einem leitfähigen Blech ausgeführt. Diese können als Erdung zum Potentialausgleich dienen
Gemäß einer weiteren Ausführungsform der Erfindung ist eine Dachluke aus einem Kunststoffmaterial im Dachelement angeordnet.

Hierbei ist es vorteilhaft, wenn die Dachluke die Trennwand überspannt, wobei der Bereich zwischen der Trennwand und der Dachluke mit einem Isolationspaneel aufgefüllt ist.

Im oberen Bereich des Containers ist die Dachluke als Druckausgleichsklappe montiert, welche bei eventuellen Verpuffungen zum Einsatz kommen kann.

Diese Aufgabe wird auch durch eine Anlage zum Betrieb einer regenerativen Energiequelle in Form einer Solaranlage gelöst umfassend eine Trafo-Station zur Anbindung an das Stromnetz und einen freistehenden Container wie oben beschrieben, bei dem in der ersten Kammer mit engem Temperaturbereich ein Batteriespeicher eingebracht ist und in der zweiten Kammer mit weiterem Temperaturbereich wenigstens die Wechselrichter zum Betrieb der Solaranlage angeordnet sind.

Auf diese Weise ist die Anbindung einer Solaranlage über die Trafostation mittels des erfindungsgemäßen Containers realisiert, sodass die zum Betrieb notwendigen elektronischen Baugruppen in einem wärmeisolierten Bereich angeordnet werden können.

Gemäß einer vorteilhaften Ausführungsform der Anlage weist der Container einen vorgegebenen Mindestabstand zu Gebäuden auf.

Nachfolgend werden einige Ausführungsbeispiele anhand der Zeichnung näher erläutert. Es zeigen:
- Figur 1: eine Ausführungsform der Erfindung in einer Seitenansicht, und
- Figur 2: eine Ausführungsform der Erfindung in einer Draufsicht.

In den Figuren sind gleiche oder funktional gleichwirkende Komponenten mit den gleichen Bezugszeichen versehen.

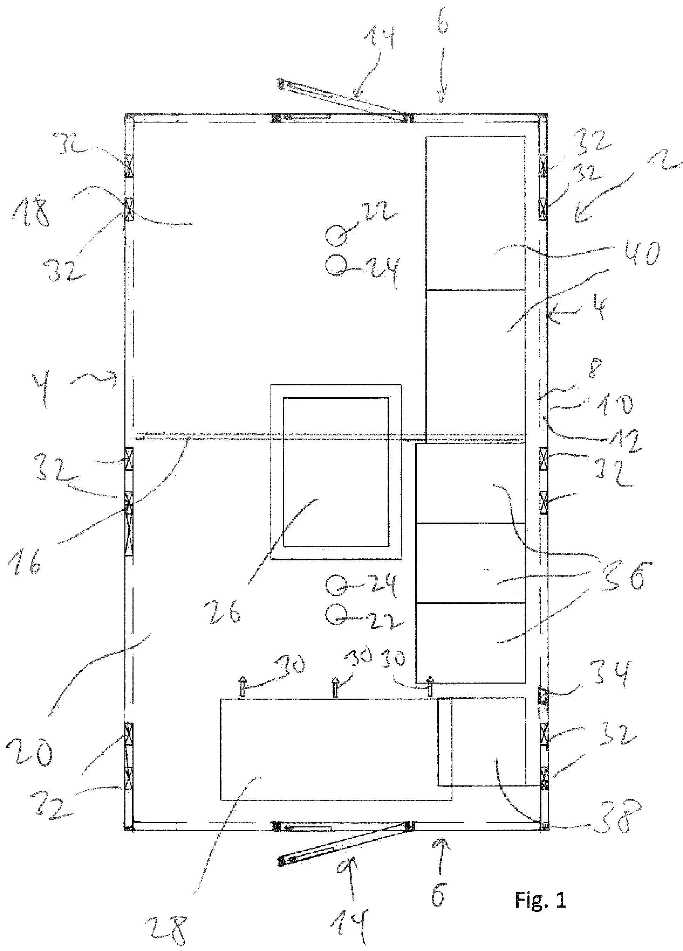

In Figur 1 ist eine Ausführungsform eines erfindungsgemäßen Containers 2 in einer Seitenansicht gezeigt. Der Container 2 weist zwei längere Seitenwände 4 entlang der Längsseite und zwei kürzere Seitenwände 6 entlang der Querseite auf. Die Seitenwände 4 und 6 sind jeweils mit einer Innendeckschicht 8 und einer Außendeckschicht 10 aufgebaut, zwischen denen ein Schaumkern 12 zur thermischen Isolation angebracht ist. Auf den beiden kürzeren Seitenwänden 6 sind jeweils eine Tür 14 angebracht.

Eine Trennwand 16 trennt das Innere des Containers 2 in eine wärmere Kammer 18 und eine kältere Kammer 20 auf. An der Decke können beispielsweise noch Beleuchtungskörper 22 sowie Brandmelder 24 für die beiden Kammern 18 und 20 angeordnet sein. Des Weiteren ist eine Dachluke 26 vorgesehen, die die Trennwand 16 überspannt. Die kältere Kammer 20 ist in der gezeigten Ausführung mit einem Klimagerät 28 versehen, welches klimatisierte Luft 30 in das Innere der kälteren Kammer 20 führt. Über eine nicht gezeigte Ventilatoreinheit in der Trennwand 16 kann auch ein Luftstrom in die wärmere Kammer 18 geführt werden.

Des Weiteren sind mehrere Durchführungen 32 in den Seitenwänden 4 vorgesehen, welche spiegelsymmetrisch oder Rotation symmetrisch angeordnet sind, sodass der Container 2 auf unterschiedliche Weise mit einem benachbarten Container verbunden werden kann bzw. je nach Orientierung des Containers 2 an andere Einheiten angeschlossen werden kann. Des Weiteren ist ein Löschwasseranschluss 34 vorgesehen, über den im Brandfall Löschwasser ins Innere des Containers 2 zugeführt werden kann.

Die Bestückung des Containers 2 erfolgt dabei so, dass elektronische Baugruppen je nach Arbeitstemperatur in die beiden Kammern 18 bzw. 20 eingesetzt werden. Im gezeigten Beispiel sind in der kälteren Kammer 20 mehrere Batteriespeicher 36 sowie eine Steuereinheit 38 eingebracht. Batteriespeicher 26 müssen üblicherweise in einem engeren Temperaturfenster, beispielsweise zwischen 20 °C und 25 °C betrieben werden, um die Vorgaben des Herstellers zu erfüllen. Die Kammer 20 wurde deshalb bezüglich ihrer Klimatisierung so ausgelegt, dass diese Vorgabe erfüllt werden kann.

In der wärmeren Kammer 18 können beispielsweise Wechselrichter 40 angebracht werden, die mit einer Solaranlage in Verbindung stehen. Die Wechselrichter 40 weisen typischerweise eine höhere Verlustleistung auf, sodass die wärmere Kammer 18 bezüglich ihrer Klimatisierung andere Vorgaben erfüllen kann, als dies bei den Batteriespeicher 36 der Fall ist. Auf diese Weise lässt sich der Aufstellungsort der elektronischen Baugruppen so wählen, dass für jede Komponente optimale Arbeitsbedingungen erreicht sind.

In einer anderen Ausführungsform wäre es auch möglich, die Trennwand 16 herausnehmbar auszugestalten oder den Container 2 ohne die Trennwand 16 zu bestücken. Der Bereich zwischen der Trennwand 16 und der Dachluke 26 kann ebenfalls mit entsprechendem Isolationsmaterial abgedichtet sein.

Die beiden gegenüberliegend angeordneten Türen 14 begrenzen einen Gang, der von bedient Personal betreten werden kann. Die elektronischen Baugruppen werden so entlang des Gangs angeordnet, dass ein Durchgang jederzeit möglich ist. Vorzugsweise werden die elektronischen Baugruppen in Schaltschränken an den Seitenwänden 4 aufbewahrt.

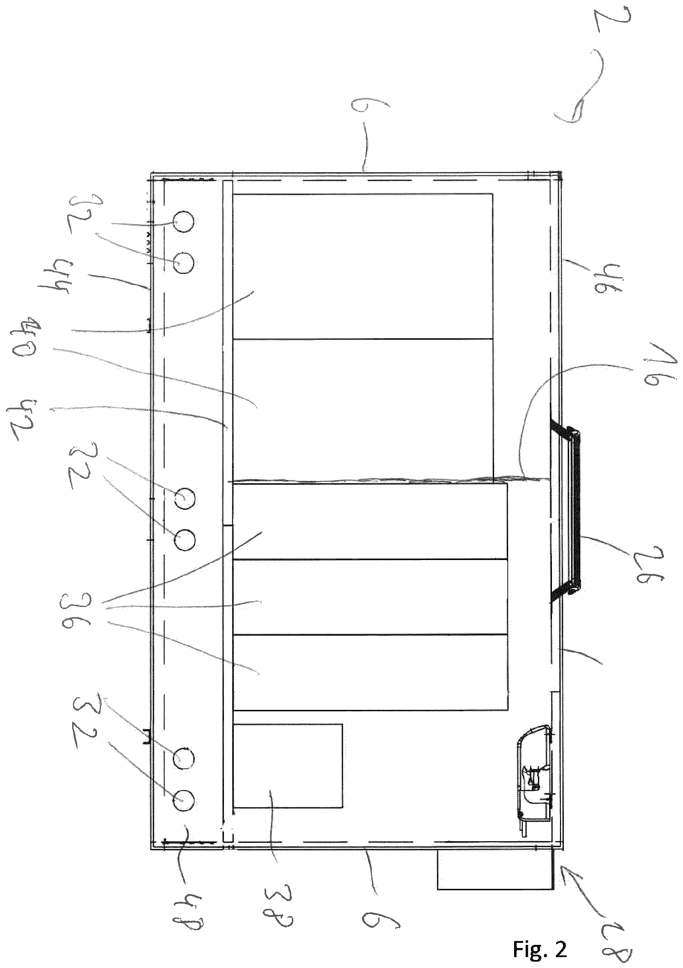

Der in Figur 1 dargestellte Aufbau des Containers 2 ist in Figur 2 nochmals in einer Seitenansicht gezeigt. Zusätzlich zu den bereits beschriebenen Merkmalen ist Figur 2 zu entnehmen, dass die elektronischen Baugruppen in Form des Wechselrichters 40, der Batteriespeicher 36 und der Steuereinheit 38 auf einem Zwischenboden 42 angeordnet sind, der oberhalb der Durchführungen oder Durchbruch 32 auf einem nicht dargestellten Ständerwerk ruht. Das Ständerwerk wiederum ist auf einem Bodenelement 44 angeordnet, welches den unteren Abschluss des Containers 2 bildet. Ebenso ist es vorgesehen, dass auf der Oberseite ein Dachelement 46 angebracht ist, welches die Dachluke 26 aufweist. Über die Durchführungen 32 können Hochspannungsleitungen zu bzw. abgeführt werden. Der Bereich unterhalb des Zwischenbodens 42 wird üblicherweise im Erdreich versenkt. Dieser Bereich, welcher in Figur 2 mit dem Bezugszeichen 48 versehen ist, kann auch eine wasserdichte Bodenwanne bilden, in der kontaminiertes Löschwasser aufgefangen wird, welches über den Löschwasseranschluss 34 im Brandfall zugeführt wurde.

Die Dachluke 26 fungiert als Druckausgleichsklappe, welche bei eventuellen Verpuffungen zum Einsatz kommen kann.

Der Container 2 kann in einer Anlage zum Betrieb einer regenerativen Energiequelle in Form einer Solaranlage eingesetzt werden, die eine Trafo-Station zur Anbindung an das Stromnetz aufweist. Die Trafostation kann mit dem freistehenden Container 2 wie oben beschrieben sein, bei dem in der ersten Kammer 20 mit engem Temperaturbereich der Batteriespeicher 36 eingebracht ist und in der zweiten Kammer 18 mit weiterem Temperaturbereich wenigstens die Wechselrichter 40 zum Betrieb der Solaranlage angeordnet sind.

In einer anderen Ausführungsform kann anstelle von Wechselrichtern einer Solaranlage ein Server in der zweiten Kammer 18 bereitgestellt werden, der über den Batteriespeicher 36 versorgt werden kann.

Der Container 2 weist Außenmaße auf, die einen Transport auf öffentlichen Straßen ermöglichen. Entlang der Querseite beträgt daher die Breite etwas weniger als 3 m, die gesamte Länge entlang der Längsseite beträgt ungefähr 5 m. Die Höhe beträgt weniger als 3 m.

Die vorstehend und die in den Ansprüchen angegebenen sowie die den Abbildungen entnehmbaren Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens und der angehängten Ansprüche in mancherlei Weise abwandelbar.

### Liste der Bezugszeichen

- 2: Container
- 4: Seitenwände
- 6: Seitenwände
- 8: Innendeckschicht
- 10: Außendeckschicht
- 12: Schaumkern
- 14: Tür
- 16: Trennwand
- 18: Kammer
- 20: Kammer
- 22: Beleuchtungskörper
- 24: Brandmelder
- 26: Dachluke
- 28: Klimagerät
- 30: Luft
- 32: Durchbruch
- 34: Löschwasseranschluss
- 36: Batteriespeicher
- 38: Steuereinheit
- 40: Wechselrichter
- 42: Zwischenboden
- 44: Bodenelement
- 46: Dachelement
- 48: Bodenwanne

## Patentansprüche

1. Container (2) für eine Anlage zum Betrieb einer regenerativen Energiequelle in Form einer Solaranlage, wobei der Container (2) für elektronische Baugruppen (36; 38; 40), insbesondere einer regenerativen Energiequelle oder eines Servers, vorgesehen ist und umfasst: Seitenwände (4; 6) mit wenigstens einer Tür (14) zum Zugang ins Innere des Containers (2), einem Bodenelement (44) und einem Deckenelement (46), wobei das Innere des Containers (2) in zwei durch eine Trennwand (16) getrennte Kammern (18; 20) aufgeteilt ist, wobei die beiden Kammern (18; 20) über wenigstens ein Klimagerät (28) unterschiedlich einstellbare zulässige Temperaturbereiche aufweisen,
**dadurch gekennzeichnet, dass** wenigstens die Seitenwände (4; 6) eine Innendeckschicht (8) und eine Außendeckschicht (10) aus elektrisch leitfähigem Material, vorzugsweise Stahlblech oder Aluminiumblech, sowie einen Schaumkern (12), vorzugsweise aus Polyurethan, zur thermischen Isolation aufweisen, wobei die elektronischen Baugruppen (36; 38; 40) entlang eines Ganges im Inneren der Kammern angeordnet sind,
und wobei in einer ersten Kammer der zwei Kammern mit engem Temperaturbereich ein Batteriespeicher eingebracht ist und in einer zweiten Kammer der zwei Kammern mit weiterem Temperaturbereich wenigstens die Wechselrichter zum Betrieb der Solaranlage angeordnet sind.

2. Container nach Anspruch 1, bei dem eine von außen anschließbare Löschwassereinrichtung (34) zum Fluten des Containers vorgesehen ist.

3. Container nach Anspruch 2, bei dem eine flüssigkeitsdichte Bodenwanne (48) zum Auffangen dekontaminierten Löschwassers vorgesehen ist.

4. Container nach einem der Ansprüche 1 bis 3, bei dem die beiden Kammern (18; 20) eine räumliche Trennung der elektronischen Baugruppen hinsichtlich ihrer Leistungsabgabe ermöglichen.

5. Container nach einem der Ansprüche 1 bis 4, bei dem die Temperaturbereiche der Kammern über ein Zwei-Verdampfer-System oder über ein Ein-Verdampfer-System und einer Lüfteranordnung regelbar sind.

6. Container nach einem der Ansprüche 1 bis 5, bei dem die Trennwand (16) mit einer verschließbaren Zugangsöffnung versehen ist, um über die Türe einen Zugang in beide Kammern oder einen Fluchtweg zu ermöglichen.

7. Container nach einem der Ansprüche 1 bis 5, bei dem zwei Türen (14) auf gegenüberliegenden Seiten des Containers vorgesehen sind, um einen Zugang in beide Kammern oder einen Fluchtweg zu ermöglichen.

8. Container nach einem der Ansprüche 6 oder 7, bei dem die Tür oder die Türen Panikverschlüsse im Inneren aufweisen.

9. Container nach einem der Ansprüche 1 bis 8, bei dem ein Zwischenboden (42) eingebracht ist, der auf einem Ständerwerk ruht und auf dem die elektronischen Baugruppen angeordnet sind.

10. Container nach Anspruche 9, bei dem der Bereich unter dem Zwischenboden als Kabelzuführung über wenigstens einen Durchbruch (32) in der Seitenwand dient.

11. Container nach Anspruche 10, bei dem an den Seitenwänden mehrere Durchbrüche (32) vorgesehen sind, die vorzugsweise spiegel- oder rotationssymmetrisch zueinander an den Seitenwänden angeordnet sind.

12. Container nach einem der Ansprüche 1 bis 11, bei dem eine Dachluke (26) aus einem Kunststoffmaterial im Dachelement angeordnet ist.

13. Container nach Anspruche 12, bei dem die Dachluke die Trennwand überspannt, wobei der Bereich zwischen der Trennwand und der Dachluke mit einem Isolationspaneel aufgefüllt ist.

14. Anlage zum Betrieb einer regenerativen Energiequelle in Form einer Solaranlage, umfassend eine Trafo-Station zur Anbindung an das Stromnetz und einen freistehenden Container nach einem der Ansprüche 1 bis 13.

15. Anlage nach Anspruch 14, bei der der Container einen vorgegebenen Mindestabstand zu Gebäuden aufweist.

## Claims

1. Container (2) for a system for operating a renewable energy source in the form of a solar-power system, the container (2) being provided for electronic assemblies (36; 38; 40), in particular a renewable energy source or a server, and comprising: lateral walls (4; 6) which have at least one door (14) for access to the interior of the container (2), a floor element (44) and a ceiling element (46), the interior of the container (2) being divided into two chambers (18; 20) separated by a partition wall (16), the two chambers (18; 20) having permissible temperature ranges which can be adjusted differently by means of at least one air conditioning unit (28),
**characterized in that** at least the lateral walls (4; 6) have an inner cover layer (8) and an outer cover layer (10) made of electrically conductive material, preferably steel sheet or aluminum sheet, and a foam core (12), preferably made of polyurethane, for thermal insulation, the electronic assemblies (36; 38; 40) being arranged along a passage inside the chambers,
and a battery storage system being introduced in a first chamber of the two chambers with a narrow temperature range, and at least the inverters for operating the solar-power system being arranged in a second chamber of the two chambers with a wider temperature range.

2. Container according to claim 1, wherein an externally connectable extinguishing-water device (34) is provided for flooding the container.

3. Container according to claim 2, wherein a liquid-tight floor tray (48) is provided for collecting decontaminated extinguishing water.

4. Container according to any of claims 1 to 3, wherein the two chambers (18; 20) enable a spatial separation of the electronic assemblies with respect to their power output.

5. Container according to any of claims 1 to 4, wherein the temperature ranges of the chambers can be controlled by means of a two-evaporator system or by means of a single-evaporator system and a fan arrangement.

6. Container according to any of claims 1 to 5, wherein the partition wall (16) is provided with a lockable access opening to allow access to both chambers or an escape route via the door.

7. Container according to any of claims 1 to 5, wherein two doors (14) are provided on opposite sides of the container to allow access to both chambers or an escape route.

8. Container according to either of claims 6 or 7, wherein the door or doors have panic locks on the inside.

9. Container according to any of claims 1 to 8, in which an intermediate floor (42) is provided which rests on a framework and on which the electronic assemblies are arranged.

10. Container according to claim 9, wherein the region under the intermediate floor serves as a cable feed through at least one opening (32) in the lateral wall.

11. Container according to claim 10, wherein a plurality of openings (32) are provided on the lateral walls, which are preferably arranged mirror symmetrically or rotationally symmetrically to one another on the lateral walls.

12. Container according to any of claims 1 to 11, wherein a roof hatch (26) made of a plastics material is arranged in the roof element.

13. Container according to claim 12, wherein the roof hatch spans the partition wall, wherein the region between the partition wall and the roof hatch is filled with an insulating panel.

14. System for operating a renewable energy source in the form of a solar-power system, comprising a transformer station for connection to the power grid and a freestanding container according to any of claims 1 to 13.

15. System according to claim 14, wherein the container has a predetermined minimum distance to buildings.

## Revendications

1. Conteneur (2) pour une installation permettant de faire fonctionner une source d'énergie renouvelable sous la forme d'une installation solaire, dans lequel le conteneur (2) est prévu pour des modules électroniques (36 ; 38 ; 40), en particulier d'une source d'énergie renouvelable ou d'un serveur, et comprend : des parois latérales (4 ; 6) comportant au moins une porte (14) pour accéder à l'intérieur du conteneur (2), un élément formant fond (44) et un élément formant plafond (46), dans lequel l'intérieur du conteneur (2) est divisé en deux chambres (18 ; 20) séparées par une paroi de séparation (16), dans lequel les deux chambres (18 ; 20) présentent des plages de températures admissibles réglables différemment par l'intermédiaire d'au moins un appareil de climatisation (28),
**caractérisé en ce qu'**au moins les parois latérales (4 ; 6) présentent une couche de recouvrement intérieure (8) et une couche de recouvrement extérieure (10) en un matériau électriquement conducteur, de préférence en tôle d'acier ou en tôle d'aluminium, ainsi qu'un noyau en mousse (12), de préférence en polyuréthane, pour l'isolation thermique, dans lequel les modules électroniques (36 ; 38 ; 40) sont disposés le long d'un couloir à l'intérieur des chambres,
et dans lequel un accumulateur à batterie est introduit dans une première chambre parmi les deux chambres avec une plage de températures étroite et au moins les onduleurs permettant de faire fonctionner l'installation solaire sont disposés dans une seconde chambre parmi les deux chambres avec une plage de températures plus large.

2. Conteneur selon la revendication 1, dans lequel un dispositif à eau d'extinction (34) pouvant être raccordé depuis l'extérieur est prévu pour inonder le conteneur.

3. Conteneur selon la revendication 2, dans lequel un bac de fond (48) étanche aux liquides est prévu pour recueillir l'eau d'extinction décontaminée.

4. Conteneur selon l'une des revendications 1 à 3, dans lequel les deux chambres (18 ; 20) permettent une séparation spatiale des modules électroniques en ce qui concerne leur puissance de sortie.

5. Conteneur selon l'une des revendications 1 à 4, dans lequel les plages de températures des chambres sont réglables par l'intermédiaire d'un système à deux évaporateurs ou par l'intermédiaire d'un système à un évaporateur et d'un agencement de ventilateur.

6. Conteneur selon l'une des revendications 1 à 5, dans lequel la paroi de séparation (16) est pourvue d'une ouverture d'accès pouvant être fermée afin de permettre un accès aux deux chambres ou à une voie d'évacuation par l'intermédiaire de la porte.

7. Conteneur selon l'une des revendications 1 à 5, dans lequel deux portes (14) sont prévues sur des côtés opposés du conteneur pour permettre l'accès aux deux chambres ou à une voie d'évacuation.

8. Conteneur selon l'une des revendications 6 ou 7, dans lequel la porte ou les portes présentent des fermetures antipanique à l'intérieur.

9. Conteneur selon l'une des revendications 1 à 8, dans lequel un fond intermédiaire (42) est introduit, lequel repose sur une ossature et sur lequel sont disposés les modules électroniques.

10. Conteneur selon la revendication 9, dans lequel la zone sous le fond intermédiaire sert d'entrée de câbles par l'intermédiaire d'au moins un passage (32) dans la paroi latérale.

11. Conteneur selon la revendication 10, dans lequel plusieurs ouvertures (32) sont prévues sur les parois latérales, lesquelles sont de préférence disposées sur les parois latérales avec une symétrie spéculaire ou de rotation les unes par rapport aux autres.

12. Conteneur selon l'une des revendications 1 à 11, dans lequel une trappe de toit (26) en matière plastique est disposée dans l'élément formant toit.

13. Conteneur selon la revendication 12, dans lequel la trappe de toit s'étend au-dessus de la paroi de séparation, dans lequel la zone entre la paroi de séparation et la trappe de plafond est remplie avec un panneau d'isolation.

14. Installation permettant de faire fonctionner une source d'énergie renouvelable sous la forme d'une installation solaire, comprenant un poste transformateur pour le raccordement au réseau électrique et un conteneur isolé selon l'une des revendications 1 à 13.

15. Installation selon la revendication 14, dans laquelle le conteneur présente une distance minimale prédéfinie par rapport aux bâtiments.
